Europäisches Patentamt

European Patent Office

Office européen des brevets

(19)

(11) Veröffentlichungsnummer: **0 006 437**
**B1**

(12) # EUROPÄISCHE PATENTSCHRIFT

(45) Veröffentlichungstag der Patentschrift:
26.08.81

(51) Int. Cl.³: **H 01 J 37/21, H 01 J 37/153**

(21) Anmeldenummer: **79101503.5**

(22) Anmeldetag: **16.05.79**

(54) **Verfahren und Vorrichtung zur Einstellung und Fehlerkorrektur eines elektronenoptischen Kondensors in einem Mikroprojektor.**

(30) Priorität: **16.06.78 DE 2827086**

(43) Veröffentlichungstag der Anmeldung:
**09.01.80 Patentblatt 80/1**

(45) Bekanntmachung des Hinweises auf die Patenterteilung:
**26.08.81 Patentblatt 81/34**

(84) Benannte Vertragsstaaten:
**FR GB NL**

(56) Entgegenhaltungen:
**DE-A-760 410**
**DE-B-2 515 549**
**DE-B-2 515 550**

(73) Patentinhaber: **SIEMENS AKTIENGESELLSCHAFT Berlin und München, Postfach 22 02 61, D-8000 München 22 (DE)**

(72) Erfinder: **Anger, Klaus, Dipl.-Ing., Milowstrasse 2, D-1000 Berlin 33 (DE)**
Erfinder: **Lischke, Burkhard, Dr., Albrechtstrasse 59a, D-1000 Berlin 41 (DE)**
Erfinder: **Frosien, Jürgen, Dipl.-Ing., Tile-Brügge-Weg 40, D-1000 Berlin 27 (DE)**

ACTORUM AG.

## Verfahren und Vorrichtung zur Einstellung und Fehlerkorrektur eines elektronenoptischen Kondensors in einem Mikroprojektor

Die Erfindung betrifft ein Verfahren und eine Vorrichtung zur Fokuseinstellung und Fehlerkorrektur eines elektronenoptischen Kondensors in einem Mikroprojektor, der zur Abbildung einer grossflächigen Transmissionsmaske auf einen Wafer mittels eines elektronenoptischen Abbildungssystems dient, wobei die Maske mit einem durch den Kondensor erzeugten Strahlenbündel achsparalleler Elektronenstrahlen beleuchtet wird.

Für die Herstellung hochintegrierter Schaltkreise werden in einem Mikroprojektor grossflächige Transmissionsmasken verkleinert auf einen sogenannten Wafer, z. B. eine einkristalline Siliziumscheibe, abgebildet. In der Prozessfolge müssen bei nacheinander durchgeführten Belichtungen einzelne Strukturdetails passgerecht aufeinandergefügt werden. Mit fortschreitender Miniaturisierung wachsen dabei die Anforderungen an das Abbildungs- und Beleuchtungssystem. Besonders kritisch ist die richtige Einstellung des Kondensors, um eine möglichst achsparallele Beleuchtung der Maske zu erhalten. Dazu muss die Elektronenquelle des Mikroprojektors exakt in der vorderen Brennebene des Kondensors liegen.

Durch Berechnen oder Messen der Brennweite lässt sich der notwendige Abstand in etwa ermitteln. Neben diesem Abstand müssen auch die Linsenfehler und Feldverzerrungen infolge äusserer Einflüsse, wie unsymmetrisch zur äusseren Achse verteilte magnetische Materialien, durch Stigmatoren korrigiert werden. Eine vollständige rechnerische Erfassung dieser Fehler ist nicht möglich. Ein Ausmessen des Kondensorlinsenfeldes müsste direkt im Mikroprojektor an seinem Einsatzort vorgenommen werden, was nur mit grossem technischem Aufwand und ohne die erforderliche Genauigkeit durchführbar wäre.

Der Erfindung liegt daher die Aufgabe zugrunde, ein Verfahren anzugeben, mit dessen Hilfe die Fokuseinstellung und Fehlerkorrektur des Kondensors direkt im Mikroprojektor mit einfachen Mitteln schnell und jederzeit wiederholbar überprüft und gegebenenfalls korrigiert werden kann. Diese Aufgabe wird erfindungsgemäss dadurch gelöst, dass das Abbildungssystem abgeschaltet wird, dass anstelle der Maske eine Ringfeldblende in den Strahlengang eingebracht wird und dass durch Brennweitenänderung des Kondensors und/oder durch Einstelländerungen von Stigmatoren das durch Schattenprojektion in einer Ebene unterhalb des Abbildungssystems entstehende Bild der Ringfeldblende in Grösse und Form der Ringfeldblende angepasst wird.

Ein Vorteil dieses Verfahrens besteht darin, dass keine Eingriffe in den Kondensor nötig sind. Anstatt die Feldsymmetrie und die Brennweite exakt auszumessen, wird eine einfache Schattenprojektion einer Ringfeldblende durchgeführt. Bei einem fehlerkorrigierten Kondensor, in dessen vorderer Brennebene sich die Elektronenquelle befindet, würden die Elektronenstrahlen den Kondensor alle achsparallel verlassen. Die Schattenprojektion ergäbe dann eine 1:1 Abbildung der Ringfeldblende. Der wirkliche Durchmesser des Schattenbildes ist daher ein Mass für die Abweichung der Fokuseinstellung von der Solleinstellung. Um beispielsweise eine Kantenlagegenauigkeit von 0,1 $\mu$m zu erhalten, darf die Winkelabweichung des Elektronenstrahls nur etwa $2 \times 10^{-5}$ rad betragen. Das bedeutet, dass die Ortsbestimmung des Schattenbildes in 1 m Entfernung von der Ringfeldblende auf 20 $\mu$m genau sein muss. Beispielsweise durch Änderung der Erregung bei einer magnetischen Kondensorlinse kann die Brennweite so lange geändert werden, bis die Fokuseinstellung stimmt.

Die Rundheit des Schattenbildes wiederum ist ein Mass für den Korrekturzustand der Kondensorlinse. Durch Erregungsänderung der dieser Linse zugeordneten Stigmatoren kann auch die Rotationssymmetrie des Kondensorlinsenfeldes optimiert werden.

Damit das erfindungsgemässe Verfahren möglichst einfach durchgeführt werden kann, empfiehlt es sich, im Mikroprojektor eine zwischen den Kondensor und das Linsensystem schwenkbare Ringfeldblende sowie eine etwa in der Ebene des Wafers in den Strahlengang einbringbare Registriereinrichtung zur Aufnahme des Schattenbildes vorzusehen. Bereits diese zwei Mittel genügen, um die Fokuseinstellung und die Rotationssymmetrie zu überprüfen.

Da die Linsenfehler mit wachsendem Achsabstand grösser werden, ist es besonders wichtig, eine korrekte Beleuchtung für diesen Bereich, also den Bildfeldrand, sicherzustellen.

In Weiterbildung der Erfindung ist daher vorgesehen, dass der Radius R der Ringfeldblende etwa gleich dem Radius der verwendeten Maske ist.

Die in der Vorrichtung verwendete Registriereinrichtung wird vorzugsweise aus einer Fotoplatte gebildet. Nach dem Entwickeln der Fotoplatte lässt sich das entstandene Bild gut ausmessen und mit der abgebildeten Ringfeldblende vergleichen. Für eine optimale Einstellung des Kondensors sind unter Umständen eine Reihe von Aufnahmen nötig.

In einer weiteren vorteilhaften Ausgestaltung der erfindungsgemässen Vorrichtung besteht die Registriereinrichtung aus einer Detektoranordnung. Dabei kann die ganze Bildebene von Einzeldetektoren bedeckt sein. Jedem Detektor ist ein bestimmter Ort der Bildebene zugeordnet. Aus den Signalen der Detektoren, die bei der Schattenprojektion beleuchtet werden, kann das Bild der Ringfeldblende rekonstruiert werden.

Die mit der Detektoranordnung erzielbaren Vorteile kommen besonders dann zum Ausdruck, wenn die Detektoranordnung aus einer Mehrzahl auf einem Kreis mit dem Radius R angeordneter Detektoren besteht, deren Signale einem Steuerglied zugeführt sind, das daraus Signale zur automatischen Korrektur der Kondensorbrennweite und/oder Stigmatoreinstellung erzeugt. Auf diese Weise ist eine automatische Regeleinrichtung geschaffen, die die Kondensator- und Stigmatoreinstellung so lange verändert, bis alle Detektoren auf dem Kreis beleuchtet sind. Damit ist erreicht, dass die die Ringfeldblende durchsetzenden Elektronenstrahlen achsparallel verlaufen.

Eine besonders einfache Überprüfung der Kondensoreinstellung und Fehlerkorrektur ergibt sich mit einer ringscheibenförmigen Detektoranordnung, über die das Bild der Ringfeldblende mittels eines üblicherweise im Abbildungslinsensystem vorhandenen Ablenksystems in mindestens zwei Richtungen geführt wird. Die Detektorsignale werden einem Steuerglied zugeführt, das durch Vergleich der Signale während der Ablenkung in unterschiedlichen Richtungen ein Signal zur Korrektur der Kondensorbrennweite und/oder Stigmatoreinstellung erzeugt. Vorzugsweise werden die Ablenkrichtungen orthogonal zueinander liegen. Die Form und Grösse des Schattenbildes lassen sich aus den so erzeugten Signalverläufen ableiten.

Anhand zweier Figuren wird im folgenden das erfindungsgemässe Verfahren und die Vorrichtung beschrieben und erläutert.

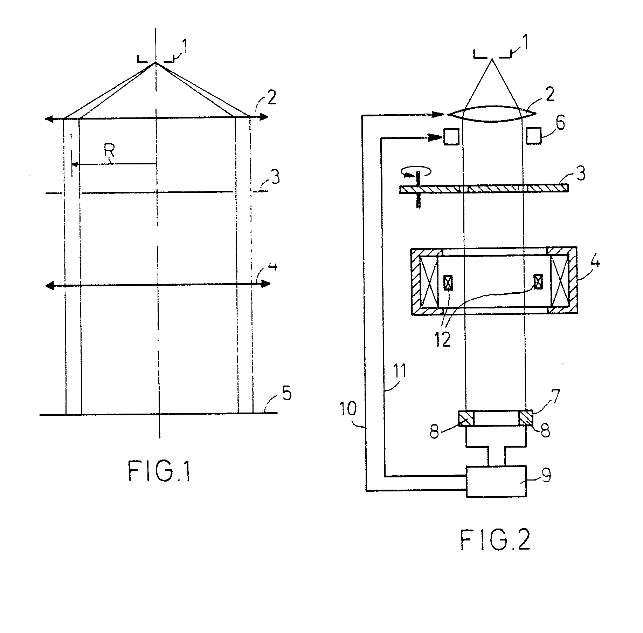

Dabei zeigt Fig. 1 schematisch den Strahlengang des Mikroprojektors bei der Fokuseinstellung und Fehlerkorrektur.

Fig. 2 zeigt den prinzipiellen Aufbau des Mikroprojektors mit der erfindungsgemässen Vorrichtung.

Bei beiden Figuren sind für gleiche Teile gleiche Bezugszeichen verwendet worden.

In Fig. 1 ist mit 1 die Elektronenquelle und mit 2 der Kondensor bezeichnet. Der Kondensor wird im einfachsten Fall aus einer einzigen elektronenoptischen Linse bestehen. Üblicherweise jedoch ist ein mehrstufiges Linsensystem vorgesehen. Unterhalb des Kondensors befindet sich eine Ringfeldblende 3 mit einem mittleren Radius R. Die Ringbreite ist gegen diesen Radius vernachlässigbar klein.

Der Vollständigkeit halber ist auch die abgeschaltete Abbildungslinse 4 (oder ein entsprechendes Abbildungslinsensystem) dargestellt, die ohne Einfluß auf den Strahlengang ist. In der Abbildungslinse befindet sich ein elektromagnetisches Ablenksystem 12 (Fig. 2), von dem nur die für eine Ablenkrichtung erforderlichen Spulen dargestellt sind. Um die Elektronenstrahlen in alle Richtungen ablenken zu können, ist mindestens noch ein weiteres Spulenpaar nötig. In einer Ebene 5, in der sich beispielsweise eine Fotoplatte befindet, wird das Schattenbild der Ringfeldblende 3 registriert. Dieses Bild wird in Grösse und Form mit der Ringfeldblende verglichen. Ist beispielsweise der Durchmesser des Bildes kleiner als der der Blende 3, so ist der Abstand der Quelle 1 vom Kondensor 2 grösser als die Brennweite des Kondensors 2, und das den Kondensor verlassende Strahlenbündel ist konvergent. Die Erregung des Kondensors muss in diesem Fall herabgesetzt werden, bis die damit verbundene Brennweitenvergrösserung ausreicht, um Brennebene und Quelle 1 zusammenfallenzulassen.

Anstelle der Erregungsänderung wäre auch eine mechanische Verschiebung des Kondensors entlang der optischen Achse denkbar, wegen der Grösse und dem Gewicht dürfte das jedoch technisch nur mit grösstem Aufwand zu realisieren sein.

Fig. 2 zeigt den prinzipiellen Aufbau des Mikroprojektors mit einer automatischen Korrekturvorrichtung. Die Anordnung der Elektronenquelle 1, des Kondensors 2 und der Abbildungslinse 4 entspricht der der Fig. 1. Unterhalb des Kondensors 2 sind zusätzliche Stigmatoren 6 angedeutet. Die Ringfeldblende 3 ist drehbar gelagert, so dass sie während der Abbildung einer hier nicht dargestellten Transmissionsmaske aus dem Strahlengang herausgeschwenkt werden kann. Als Registriereinrichtung dient in diesem Ausführungsbeispiel eine Detektoranordnung 7, die aus einer Mehrzahl auf einem Kreis mit dem Radius R angeordneter Detektoren 8 besteht. Die Ausgänge aller Detektoren 8 sind einem Steuerglied 9 zugeführt. Dieses Steuerglied erzeugt je ein Ausgangssignal 10 und 11 für die Korrektur der Kondensorbrennweite und/oder die Stigmatoreinstellung.

**Patentansprüche**

1. Verfahren zur Fokuseinstellung und Fehlerkorrektur eines elektronenoptischen Kondensors in einem Mikroprojektor, der zur Abbildung einer grossflächigen Transmissionsmaske auf einen Wafer mittels eines elektronenoptischen Linsensystems dient, wobei die Maske mit einem durch den Kondensor erzeugten Strahlenbündel achsparalleler Elektronenstrahlen beleuchtet wird, dadurch gekennzeichnet, dass das Linsensystem (4) abgeschaltet wird, dass anstelle der Maske eine Ringfeldblende (3) in den Strahlengang eingebracht wird und dass durch Brennweitenänderung des Kondensors (2) und/oder durch Einstelländerungen von Stigmatoren (6) das durch Schattenprojektion in einer Ebene (5) unterhalb des Linsensystems (4) entstehende Bild der Ringfeldblende (3) in Grösse und Form der Ringfeldblende (3) angepasst wird.

2. Vorrichtung zur Durchführung des Verfahrens nach Anspruch 1, gekennzeichnet durch eine zwischen Kondensorlinse (2) und Linsensystem (4) in den Strahlengang schwenkbare Ringfeldblende (3) sowie eine etwa in der Ebene des Wafers in den Strahlengang einbringbare Registriereinrichtung (5, 7) zur Aufnahme des Schattenbildes.

3. Vorrichtung nach Anspruch 2, dadurch gekennzeichnet, dass der Radius R der Ringfeldblende (3) etwa gleich dem Radius der Maske ist.

4. Vorrichtung nach Anspruch 2 oder 3, dadurch gekennzeichnet, dass als Registriereinrichtung eine Fotoplatte (5) vorgesehen ist.

5. Vorrichtung nach Anspruch 2 oder 3, dadurch gekennzeichnet, dass die Registriereinrichtung aus einer Detektoranordnung (7) besteht.

6. Vorrichtung nach Anspruch 5, dadurch gekennzeichnet, dass die Detektoranordnung (7) aus einer Mehrzahl auf einem Kreis mit dem Radius R angeordneter Detektoren (8) besteht, deren Signale einem Steuerglied (9) zugeführt sind, das daraus Signale (10, 11) zur automatischen Korrektur der Kondensorbrennweite und/oder Stigmatoreinstellung erzeugt.

7. Vorrichtung nach Anspruch 5 mit einem Ablenksystem zwischen der Ringfeldblende und der Registriereinrichtung, gekennzeichnet durch eine ringscheibenförmige Detektoranordnung, über die das Bild der Ringfeldblende (3) durch das Ablenksystem (12) mindestens in zwei Richtungen geführt wird, und ein Steuerglied, dem die Detektorsignale zugeführt sind und das durch Vergleich der Signale während unterschiedlicher Ablenkrichtungen ein Signal zur Korrektur der Kondensorbrennweite und/oder Stigmatoreinstellung erzeugt.

## Claims

1. A process for adjusting the focal point and correcting errors of an optoelectronic condenser in a micro-projector which serves to focus a large surface of transmission mask onto a wafer by means of an optoelectronic lens system, where the mask is illuminated with an axially parallel electron-beam produced by the condenser, characterised in that whilst the lens system (4) is switched off the mask is replaced by a ring-field diaphragm (3) is placed into the beam path, and that by changing the focal length of the condenser (2) and/or by changing the adjustment of stigmators (6) the image of the ring-field diaphragm (3) produced by shadow projection in a plane (5) below the lens system (4), is matched to the ringfield diaphragm (3) in form and size.

2. A device for implementing the process as claimed in Claim 1, characterised by the provision of both a ringfield diaphragm (3) which can be swung into the beam path between the condenser lens (2) and lens system (4) and of a recording device (5, 7) which can be placed in the beam path approximately in the plane of the wafer, for recording the shadow image.

3. A device as claimed in Claim 2, characterised in that the radius R of the ring-field diaphragm (3) is substantially equal to the radius of the mask.

4. A device as claimed in Claim 2 or Claim 3, characterised in that a photo-sensitive plate (5) is provided as recording device.

5. A device as claimed in Claim 2 or Claim 3, characterised in that the recording device consists of a detector arrangement (7).

6. A device as claimed in Claim 5, characterised in that the detector arrangment (7) consists of a plurality of detectors (8) arranged on a circle having the radius R and whose signals are fed to a control element (9) which produces signals (10, 11) therefrom for automatically correcting the focal length of the condenser and/or adjusting the stigmator.

7. A device as claimed in Claim 5, which comprises a deflecting system between the ring-field diaphragm and the recording device, characterised by a ring-shaped detector arrangement via which the image of the ring-field diaphragm (3) is directed in at least two directions by means of the deflecting system (12), and by a control element to which the detector signals are fed and which produces a signal for correcting the focal length of the condenser and/or adjusting the stigmator by comparing signals during different deflection directions.

## Revendications

1. Procédé pour le réglage du foyer et la correction de défauts d'un condensateur optoélectronique dans un microprojecteur, servant à produire l'image d'un masque de transmission de grande surface sur une pastille, à l'aide d'un système de lentilles optoélectroniques, dans lequel le masque est éclairé au moyen d'un faisceau électronique de rayons électroniques parallèles à l'axe et produits par le condensateur, caractérisé par le fait que le système de lentilles est mis hors service, qu'à la place du masque on introduit un diaphragme de champ annulaire (3) dans la trajectoire du faisceau et que par une modification de la distance focale du condensateur (2) et/ou par une modification du réglage de stigmateurs (6), l'image du diaphragme de champ annulaire (3) qui se forme par projection d'ombre dans un plan (5) situé sous le système de lentilles (4), est adapté, du point de vue de la dimension et de la forme, au diaphragme de champ annulaire (3).

2. Dispositif pour la mise en œuvre du procédé selon la revendication 1, caractérisé par un diaphragme de champ annulaire (3) susceptible d'être basculé dans la trajectoire des rayons, entre une lentille de condensateurs (2) et le système de lentilles (4), ainsi que par un dispositif d'enregistrement (5, 7), susceptible d'être amené dans la trajectoire des rayons, sensiblement au neveau de la pastille, pour réaliser la prise de vue de la photographie par ombre.

3. Dispositif selon la revendication 2, caractérisé par le fait que le rayon R du diaphragme de champ annulaire (3) est sensiblement égal au rayon du masque.

4. Dispositif selon la revendication 2 ou 3, caractérisé par le fait que le dispositif d'enregistrement est constitué par une plaque photographique (5).

5. Dispositif selon la revendication 2 ou 3, caractérisé par le fait que le dispositif d'enregistrement est constitué par un dispositif détecteur (7).

6. Dispositif selon la revendication 5, caractérisé par le fait que le dispositif détecteur (7) est constitué par plusieurs détecteurs (8) disposés sur un cercle de rayon R et dont les signaux sont appliqués à un organe de commande (9) qui en forme des signaux (10, 11) pour la correction automatique de la distance focale du condensateur et/ou pour le réglage automatique de stigmateurs.

7. Dispositif selon la revendication 5, du type à système de déflection entre le diaphragme de champ annulaire et le dispositif d'enregistrement, caractérisé par un dispositif détecteur (7) de la forme d'un disque annulaire à l'aide duquel l'image du diaphragme de champ annulaire (3) est guidée par le système déflecteur (12) au moins suivant deux directions et par un organe de commande auquel sont appliqués les signaux du dispositif détecteur et qui, par comparaison entre les signaux produits, pendant les directions de déflection différentes, un signal pour corriger la distance focale du condensateur et/ou le réglage des stigmateurs.

FIG.1

FIG.2